# EUROPÄISCHE PATENTANMELDUNG

(11) **EP 3 361 187 A1**
(43) Veröffentlichungstag der Anmeldung: **15.08.2018**
(21) Anmeldenummer: 17020047.1
(22) Anmeldetag: 08.02.2017
(51) Int. Cl.: F25B 9/00, F25B 9/14, F25B 19/00, H01F 6/04, H01L 23/46

(54) **VERFAHREN UND VORRICHTUNG ZUM KÜHLEN EINES VERBRAUCHERS SOWIE SYSTEM MIT ENTSPRECHENDER VORRICHTUNG UND VERBRAUCHER**

(71) Anmelder: Linde Aktiengesellschaft, 80331 München (DE)
(72) Erfinder: Alekseev, Alexander, 82515 Wolfratshausen (DE)
(74) Vertreter: Imhof, Dietmar

(57) **Zusammenfassung**

Es wird ein Verfahren zur Kühlung eines Verbrauchers unter Verwendung von flüssigem Stickstoff, der in einem Kreislauf geführt, durch indirekten Wärmeaustausch mit abgekühltem flüssigem Stickstoff abgekühlt und einem Wärmeaustausch mit dem Verbraucher unterworfen wird, vorgeschlagen. Dabei ist vorgesehen, dass der zur Abkühlung des in den Kreislauf geführten flüssigen Stickstoffs verwendete abgekühlte flüssige Stickstoff zu einem ersten Anteil in einem offenen Kältesystem (10) durch Druckreduktion und Abführen von sich bildendem Stickstoffdampf und zu einem zweiten Anteil in einem geschlossenen Kältesystem (20) unter Verwendung einer oder mehrerer Kältemaschinen, die insbesondere eine oder mehrere Stirling- und/oder eine oder mehrere, unter Verwendung von Neon und/oder Helium betriebene Brayton-Kältemaschinen umfassen, abgekühlt wird, das offene Kältesystem (10) und das geschlossene Kältesystem (20) zum Kühlen einer Stromführung (1) mit einem ersten Ende und einem zweiten Ende verwendet wird, wobei das offene Kältesystem (10) an dem ersten Ende der Stromführung (1) und das geschlossene Kältesystem (20) an dem zweiten Ende der Stromführung (1) angeordnet wird, und Kühlleistung einem ersten Zeitraum in einer ersten, geringeren Gesamtkühlleistungsmenge und in in einem zweiten Zeitraum einer zweiten, höheren Gesamtkühlleistungsmenge bereitgestellt wird, wobei ein erster Anteil der Gesamtkühlleistungsmenge mittels des offenen (10) und ein zweiter Anteil der Gesamtkühlleistungsmenge mittels des geschlossenen Kältesystems (20) bereitgestellt wird und der erste Anteil in dem ersten Zeitraum auf einen geringeren Wert als in dem zweiten Zeitraum eingestellt wird. Eine entsprechende Vorrichtung und ein System (100) aus einer derartigen Vorrichtung sowie einem entsprechenden Verbraucher sind ebenfalls Gegenstand der Erfindung.

## Beschreibung

Die vorliegende Erfindung betrifft ein Verfahren und eine Vorrichtung zum Kühlen eines Verbrauchers sowie ein System mit einer entsprechenden Vorrichtung und einem Verbraucher gemäß den Oberbegriffen der jeweiligen unabhängigen Patentansprüche.

### Stand der Technik

Hoch- und Mittelspannungskabel sowie Stromschienen können als Hochtemperatursupraleiter (HTSL) ausgebildet sein. Solche Kabel und Stromschienen können sowohl Gleichstrom als auch Wechselstrom führen und werden nachfolgend auch als »HTSL-Stromführungen« bezeichnet. Sie bedürfen einer Kühlung auf eine Temperatur von weniger als 100 K, bevorzugt weniger als 80 K.

Wenngleich die vorliegende Erfindung nachfolgend überwiegend unter Bezugnahme auf HTSL-Stromführungen als Verbraucher beschrieben wird, eignet sie sich in der gleichen Weise auch zur Kühlung anderer Verbraucher, die eine Kälteleistung auf einem vergleichbaren Kühltemperaturniveau benötigen, insbesondere Supraleitermaterialien, jedoch auch beispielsweise Kabel, Stromführungen und weitere Strukturen aus konventionellen Metallen wie Kupfer und Aluminium.

Zur Kühlung entsprechender Verbraucher sind aus dem Stand der Technik unterschiedlichste Verfahren und Vorrichtungen bekannt. Diese arbeiten beispielsweise wie nachfolgend zusammengefasst:
- Typischerweise wird Flüssigstickstoff in einer Pumpe druckerhöht, in einem Unterkühler auf die erforderliche Kühltemperatur gekühlt, zum Verbraucher geleitet, dort angewärmt und schließlich wieder zur Pumpe zurückgeführt. Entsprechender Stickstoff wird auch als »Kreislaufstickstoff« bezeichnet. Die Bezeichnung »Unterkühler« wird verwendet, weil die Flüssigkeit nach einer entsprechenden Kühlung eine unterkühlte Flüssigkeit darstellt.
- Es sind auch Schaltungen mit der Unterkühlung des Kreislaufstickstoffs stromauf der Pumpe kombiniert mit einer Unterkühlung stromab der Pumpe bekannt. Dafür werden zwei Unterkühlungswärmetauscher benötigt und im Unterkühler platziert.
- Der Wärmetauscher in einem Unterkühler stellt in der einfachsten Ausführung eine Rohrschlange dar, die in einem Flüssigstickstoffbad (»Badstickstoff«) platziert wird. Der wärmere Kreislaufstickstoff wird innerhalb der Rohrschlange geführt und durch den außenliegenden, kälteren Badstickstoff gekühlt. Der Badstickstoff verdampft hierbei. Alternativ zu Rohrschlangenwärmetauschern können andere Typen von Wärmetauschern eingesetzt werden.
- Die in dem Unterkühler durch das Verdampfen entstehenden Verluste an Badstickstoff werden typischerweise durch das Nachfüllen von frischem flüssigem Stickstoff aus einem Vorratsbehälter kompensiert.
- Der Druck im Kühlkreislauf stromab der Pumpe wird so gewählt, dass der Kreislaufstickstoff stets flüssig bleibt und keine Dampfblasen entstehen. Aus thermodynamischer Sicht bedeutet dies, dass der Druck im Kreislauf immer höher sein sollte als im Bad des Unterkühlers, und dass der Kreislaufstickstoff nicht über den Siedepunkt angewärmt werden darf.
- Die tiefste Temperatur des Kreislaufstickstoffs wird am Austritt aus dem Unterkühler erreicht. Diese Temperatur wird im Wesentlichen durch die Temperatur des im Unterkühler eingesetzten Badstickstoffs (und den Wärmeübergang im Unterkühler) bestimmt.
- Zur Temperaturerniedrigung wird der Druck des Badstickstoffs durch kontinuierliches Abpumpen unter Verwendung einer mechanischen (in der Regel ölgeschmierten) Vakuumpumpe reduziert. Die untere Grenze der erreichbaren Temperatur liegt bei etwa 63 K, was einem Dampfdruck von ca. 0,13 bar entspricht. Bei tieferen Temperaturen würde der Badstickstoff gefrieren.
- Die Temperatur des Badstickstoffs kann auch verringert werden, indem ein oder mehrere Kältemaschinen (auch als Kryokühler bezeichnet) in den Unterkühler integriert werden. Die eine oder die mehreren Kältemaschinen kühlen und verflüssigen/rekondensieren den bei der Kühlung verdampfenden Badstickstoff bis auf die erforderliche Kühltemperatur; eine Vakuumpumpe wird in diesem Fall nicht benötigt. Als Kryokühler werden typischerweise die sogenannten Brayton- oder die sogenannten Stirling-Kühler eingesetzt. Entsprechende Kühlsysteme sind als geschlossene Systeme ausgebildet.

Die DE 10 2013 011 212 A1 offenbart eine Vorrichtung der beschriebenen Art, wobei ein Hauptaspekt darin besteht, wie die Volumenänderung des Kreislaufstickstoffs gehandhabt werden kann. Es wird vorgeschlagen, eine Leitung zwischen dem Vorratsbehälter und dem Stickstoffkreislauf, die stromauf der Pumpe mündet, einzusetzen. Die EP 1 355 114 A3 schlägt aus einem vergleichbaren Zweck vor, einen Ausgleichsbehälter in den Kreislauf einzubringen. In kommerziell verfügbaren Systemen werden ebenfalls Ausgleichsbehälter, die jedoch typischerweise in den Unterkühler integriert sind, eingesetzt.

In der DE 197 55 484 A1 wird ein Verfahren beschrieben, bei dem anstelle von Kreislaufstickstoff ein flüssiges Gemisch eingesetzt wird, das überwiegend aus Stickstoff und Sauerstoff besteht.

Der Einsatz einer mechanischen Vakuumpumpe für die Kälteerzeugung im Unterkühler stellt (aus Investitionskostensicht) eine relativ preisgünstige, jedoch energetisch ineffiziente Lösung dar. Dies liegt insbesondere daran, dass die wertvolle (da bei sehr tiefen Temperaturen vorliegende) Kälte des abgesaugten kalten Stickstoffdampfs nicht genutzt sondern vernichtet wird. Der Einsatz von Kältemaschinen ist energetisch in der Regel vorteilhaft, jedoch sind entsprechende Geräte relativ teuer, sodass ihr Einsatz häufig nicht wirtschaftlich ist.

Die vorliegende Erfindung stellt sich daher die Aufgabe, verbesserte Verfahren und Vorrichtungen zur Kühlung entsprechender Verbraucher bereitzustellen.

### Offenbarung der Erfindung

Vor diesem Hintergrund schlägt die vorliegende Erfindung ein Verfahren und eine Vorrichtung zur Kühlung eines Verbrauchers, insbesondere einer Stromführung, vorzugsweise einer HTSL-Stromführung, sowie ein System mit einer entsprechenden Vorrichtung und einem Verbraucher mit den Merkmalen der unabhängigen Patentansprüche vor. Bevorzugte Ausgestaltungen sind Gegenstand der abhängigen Patentansprüche sowie der nachfolgenden Beschreibung.

Die vorliegende Erfindung beruht auf der Erkenntnis, dass es besonders vorteilhaft ist, zur Kühlung eines entsprechenden Verbrauchers eine Kombination aus einem offenen und einem geschlossenen Kühlsystem einzusetzen. Das offene Kühlsystem beruht dabei, wie zuvor erläutert, auf einer Flüssigstickstoffverdampfung, das geschlossene Kühlsystem arbeitet unter Verwendung einer integrierten Kältemaschine.

Besondere Vorteile ergeben sich dann, wenn das geschlossene und das offene Kühlsystem an unterschiedlichen Positionen des Verbrauchers, bei der Kühlung einer Stromführung insbesondere an unterschiedlichen Enden, angeordnet werden. Dies ist daher erfindungsgemäß vorgesehen.

Das, wie erläutert, investitionskostenintensivere geschlossene Kühlsystem wird dabei insbesondere derart ausgelegt, dass seine Kälteleistung 25 bis 75 % der verfügbaren Kälteleistung des gesamten Kühlsystems, d.h. der Kombination aus dem offenen und dem geschlossenen Kühlsystem, beträgt.

Das offene Kühlsystem wird derart ausgelegt, dass es in einem Minimallastbetrieb betrieben werden kann, in welchem zumindest der Kreislaufstickstoff umgewälzt wird. In dem Minimallastbetrieb wird die aktive Kühlung durch das Abpumpen des Badstickstoffs auf ein systemspezifisches Minimum reduziert.

Beide Kühlsysteme (das offene und das geschlossene Kühlsystem) sind kontinuierlich in Betrieb. Der Kältebedarf des Verbrauchers wird dabei bevorzugt durch die Kälteleistung des geschlossenen Systems abgedeckt. Das offene Kältesystem wird dabei in dem erwähnten Minimallastbetrieb betrieben. Seine Kälteleistung deckt nur die nicht durch das geschlossene Kältesystem erbringbare Kälteleistung ab.

Durch die erfindungsgemäß vorgeschlagenen Maßnahmen lässt sich eine Reihe von Vorteilen erzielen. Im Rahmen der vorliegenden Erfindung kann ein Teil des Kältebedarfs in erster Linie durch das effiziente geschlossene Kühlsystem abgedeckt werden. Hierdurch erhöht sich die Energieeffizienz bei der Kühlung. Lediglich benötigte Leistungsspitzen werden durch das weniger effiziente offene System abgedeckt. Das erfindungsgemäß vorgeschlagene Gesamtsystem aus offenem und geschlossenem Kältesystem ist deutlich kosteneffizienter als ein ausschließlich geschlossenes Kältesystem, da deutlich geringere Mengen an Stickstoff umgewälzt werden müssen. Insbesondere durch den Einsatz der unterschiedlichen Kältesysteme an unterschiedlichen Positionen des Verbrauchers lässt sich die kühlbare Strecke deutlich erhöhen. Beispielsweise kann im Fall einer HTSL-Stromführung die zu kühlende Stromführungslänge deutlich erhöht werden.

HTSL-Stromführungen werden typischerweise in unterschiedlichen Lastmodi betrieben. Diese umfassen Unterlast, Auslegungslast und Überlast und führen zu unterschiedlichem Kühlbedarf. Ein wesentlicher Vorteil der vorliegenden Erfindung besteht auch darin, dass durch eine Leistungserhöhung des offenen Kühlsystems bei Überlast der HTSL-Stromführung auftretende Spitzen in der Kühlleistungsanforderung abgefangen werden können.

Insgesamt schlägt die vorliegende Erfindung ein Verfahren zur Kühlung eines Verbrauchers unter Verwendung von flüssigem Stickstoff, der in einem Kreislauf geführt, durch indirekten Wärmeaustausch mit abgekühltem flüssigem Stickstoff abgekühlt und einem Wärmeaustausch mit dem Verbraucher unterworfen wird, vor. Wie zuvor erwähnt, ist bekannt, entsprechenden »Kreislaufstickstoff« durch indirekten Wärmetausch mit weiterem abgekühltem Stickstoff zu kühlen.

Im Rahmen der vorliegenden Erfindung ist nun vorgesehen, dass der zur Abkühlung des in den Kreislauf geführten flüssigen Stickstoffs verwendete abgekühlte flüssige Stickstoff zu einem ersten Anteil in einem offenen Kältesystem durch Druckreduktion und Abführen von sich aufgrund der Druckreduktion bildendem Stickstoffdampf und zu einem zweiten Anteil in einem geschlossenen Kältesystem unter Verwendung einer oder mehrerer Kältemaschinen abgekühlt wird.

Grundsätzlich wird im Rahmen der vorliegenden Erfindung unter einem »offenen« Kältesystem ein Kältesystem verstanden, das darauf beruht, dass ein Kältemittel verdampft und die bei der Verdampfung gebildeten Kältemitteldämpfe aus dem Kältesystem ausgeführt werden. Ein offenes Kältesystem zeichnet sich damit durch einen kontinuierlichen Verbrauch von Kältemittel aus, das beispielsweise aus einem Speichertank nachgeliefert wird.

Unter einem »geschlossenen« Kältesystem wird dagegen hier ein Kältesystem verstanden, bei dem ein Kältemittel im Kreislauf geführt und dabei abgekühlt wird. Bei einem geschlossenen Kältesystem ergibt sich grundsätzlich kein zwangsläufiger Verbrauch des Kältemittels.

Im Rahmen der vorliegenden Erfindung umfassen die eine oder die mehreren Kältemaschinen, die in dem geschlossenen Kältesystem zum Einsatz kommen, insbesondere eine oder mehrere Stirling- und/oder eine oder mehrere, unter Verwendung von Neon und/oder Helium betriebene Brayton-Kältemaschinen. Kältemaschinen der genannten Art sind aus dem Stand der Technik bekannt.

Eine Stirling-Kältemaschine ist eine auf dem Prinzip des Stirling-Motors basierende Kältemaschine. Brayton-Kältemaschinen arbeiten mit einem Edelgas oder Edelgasgemisch wie Helium und/oder Neon als Arbeitsgas. Dieses wird »warm« einem Verdichter zugeführt und in diesem verdichtet. Verdichtungswärme wird unter Verwendung eines geeigneten Kühlmittels wie Wasser, Luft oder flüssigem Stickstoff abgeführt. Das Arbeitsgas wird entspannt, zur Kühlung verwendet und anschließend wieder dem Verdichter zugeführt. Vor der Entspannung des Arbeitsgases wird dieses im Gegenstrom zu dem zuvor zur Kühlung verwendeten Arbeitsgas abgekühlt.

Wie erläutert, kann zur Abkühlung des Stickstoffs in dem offenen Kältesystem dessen Druck verringert und hierdurch verdampfende Stickstoff abgeführt werden. In einem entsprechenden offenen Kältesystem können jedoch grundsätzlich auch andere Einrichtungen zur Druckreduzierung eingesetzt werden.

Das erfindungsgemäße Verfahren umfasst, wie bereits angesprochen, dass das offene Kältesystem und das geschlossene Kältesystem an unterschiedlichen Positionen des Verbrauchers angeordnet werden. Die zu kühlenden Verbraucher lassen sich hierdurch deutlich größer dimensionieren als dies bei der Anordnung an nur einer Position möglich wäre, weil sich über eine Kühlstrecke ergebende Kälteverluste auf diese Weise besser ausgleichen lassen. Die Hauptkälteleistung kann in diesem Fall an einer ersten Position erbracht werden, an einer zweiten Position müssen lediglich noch Kälteverluste ausgeglichen werden.

Das erfindungsgemäße Verfahren wird zum Kühlen einer Stromführung mit einem ersten Ende und einem zweiten Ende verwendet, wobei das offene Kältesystem an dem ersten Ende der Stromführung und das geschlossene Kältesystem und dem zweiten Ende der Stromführung angeordnet wird. Auf diese Weise lassen sich beispielsweise deutlich größere Leitungslängen realisieren als dies in Verfahren gemäß dem Stand der Technik möglich ist.

Wie bereits erläutert, können insbesondere HTSL-Stromführungen in unterschiedlichen Lastmodi betrieben werden. Entsprechendes gilt jedoch auch grundsätzlich für andere Verbraucher, die im Rahmen der vorliegenden Erfindung gekühlt werden können. Zur Bedienung der unterschiedlichen Kältebedarfe ist daher vorgesehen, dass das Verfahren zur Bereitstellung von Kühlleistung in einer ersten, geringeren Gesamtkühlleistungsmenge in einem ersten Zeitraum und in einer zweiten, höheren Gesamtkühlleistungsmenge in einem zweiten Zeitraum verwendet wird. Auf diese Weise kann die bereitgestellte Kälteleistung rasch und flexibel an den Kältebedarf angepasst werden.

Wie bereits grundsätzlich angesprochen, ist es hierbei besonders vorteilhaft, wenn ein erster Anteil der Gesamtkühlleistungsmenge durch das offene Kältesystem und ein zweiter Anteil der Gesamtkühlleistungsmenge durch das geschlossene Kältesystem bereitgestellt wird, wobei der erste Anteil in dem ersten Zeitraum auf einen geringeren Wert eingestellt wird als in dem zweiten Zeitraum. Dies ist daher erfindungsgemäß ebenfalls vorgesehen. Mit anderen Worten dient das energetisch ungünstigere offene Kältesystem also vorteilhafterweise zur Bedienung von Bedarfsspitzen, wohingegen das energetisch günstigere geschlossene Kältesystem den Grundbedarf an Kälte deckt. Für eine entsprechende Einstellung kann beispielsweise ein geeignetes Steuer- bzw. Regelsystem vorgesehen sein, das beispielsweise eine elektrische Stromstärke in einer HTSL-Stromführung als Eingangsgröße auswertet. Vorteilhafterweise wird daher in einem erfindungsgemäßen Verfahren der zweite Anteil in dem ersten Zeitraum auf denselben Wert eingestellt wie in dem zweiten Zeitraum.

Insbesondere kann der in dem Kreislauf geführte flüssige Stickstoff in dem erfindungsgemäß vorgeschlagenen Verfahren dem offenen und in dem geschlossenen Kältesystem jeweils von einem Temperaturniveau von 70 bis 78 K, beispielsweise ca. 74 K auf ein Temperaturniveau von 65 bis 70 K, beispielsweise ca. 67 K abgekühlt werden. Durch die Kühlung des Verbrauchers wird der im Kreislauf geführte flüssige Stickstoff auf beispielsweise ca. 74 K erwärmt. In dem offenen Kältesystem kann ein Unterkühler eingesetzt werden, der flüssigen Stickstoff enthält, welcher durch Abpumpen mittels einer Vakuumpumpe auf einen Druck von beispielsweise ca. 0,2 bar gebracht wird und hierdurch eine Temperatur von beispielsweise ca. 65 K erreicht. Der in dem Kreislauf geführte flüssige Stickstoff wird in dem offenen und in dem geschlossenen Kältesystem vorteilhafterweise auf einem Druckniveau von 5 bis 20 bar abgekühlt wird, wozu eine entsprechende (Kreislauf-)Pumpe bereitgestellt ist.

Die vorliegende Erfindung betrifft ferner eine Vorrichtung zur Kühlung eines Verbrauchers unter Verwendung von flüssigem Stickstoff, die dafür eingerichtet ist, den flüssigen Stickstoff in einem Kreislauf zu führen, durch indirekten Wärmeaustausch mit abgekühltem flüssigem Stickstoff abzukühlen und einem Wärmeaustausch mit dem Verbraucher zu unterwerfen.

Die Vorrichtung zeichnet sich dadurch aus, dass zur Abkühlung eines ersten Anteils des flüssigen Stickstoffs, der zur Abkühlung des in den Kreislauf geführten flüssigen Stickstoffs vorgesehen ist, ein offenes Kältesystem bereitgestellt ist, das dafür eingerichtet ist, den ersten Anteil des flüssigen Stickstoffs durch Druckreduktion und Abführen von sich bildendem Stickstoffdampf abzukühlen, zur Abkühlung eines zweiten Anteils des flüssigen Stickstoffs, der zur Abkühlung des in dem Kreislauf geführten flüssigen Stickstoffs vorgesehen ist, ein geschlossenes Kältesystem bereitgestellt ist, das eine oder mehrere Kältemaschinen umfasst, die insbesondere eine oder mehrere Stirling- und/oder eine oder mehrere, unter Verwendung von Neon und/oder Helium betriebene Brayton-Kältemaschinen umfassen, dass das offene Kältesystem und das geschlossene Kältesystem zum Kühlen einer Stromführung mit einem ersten Ende und einem zweiten Ende eingerichtet sind, wobei das offene Kältesystem an dem ersten Ende der Stromführung und das geschlossene Kältesystem an dem zweiten Ende der Stromführung angeordnet wird, und dass die Vorrichtung dafür eingerichtet ist, Kühlleistung einem ersten Zeitraum in einer ersten, geringeren Gesamtkühlleistungsmenge und in in einem zweiten Zeitraum einer zweiten, höheren Gesamtkühlleistungsmenge bereitzustellen, wobei ein erster Anteil der Gesamtkühlleistungsmenge mittels des offenen Kältesystems und ein zweiter Anteil der Gesamtkühlleistungsmenge mittels des geschlossenen Kältesystems bereitgestellt wird und der erste Anteil in dem ersten Zeitraum auf einen geringeren Wert als in dem zweiten Zeitraum eingestellt wird.

Bezüglich Merkmalen und Vorteilen der erfindungsgemäß vorgeschlagenen Vorrichtung wird auf die obigen, das erfindungsgemäße Verfahren betreffenden Erläuterungen ausdrücklich verwiesen.

Die entsprechenden Erläuterungen gelten auch für das erfindungsgemäß ebenfalls vorgeschlagene System, das einen zu kühlenden Verbraucher umfasst und erfindungsgemäß eine Vorrichtung der soeben erläuterten Art aufweist.

Die Erfindung wird nachfolgend unter Bezugnahme auf die beigefügten Zeichnungen näher erläutert, in der Ausführungsformen der Erfindung veranschaulicht sind.

### Kurze Beschreibung der Zeichnung

Figur 1a und Figur 1b zeigen Systeme gemäß dem Stand der Technik in vereinfachter schematischer Darstellung.
Figur 2 zeigt ein System gemäß einer Ausführungsform der Erfindung in vereinfachter schematischer Darstellung.

In den Figuren sind gleiche oder einander funktionell entsprechende Elemente mit identischen Bezugszeichen angegeben. Auf eine wiederholte Erläuterung derartiger Elemente wird der Übersichtlichkeit halber verzichtet.

### Ausführliche Beschreibung der Zeichnung

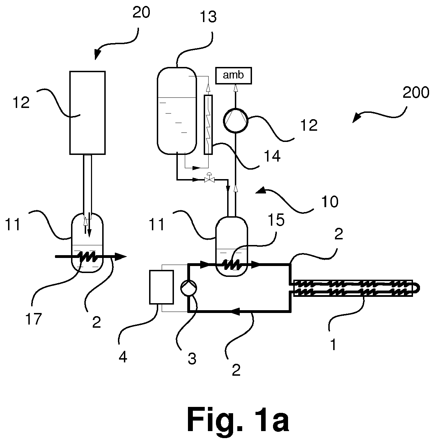

In Figur 1a ist ein System gemäß dem Stand der Technik in vereinfachter schematischer Darstellung gezeigt und insgesamt mit 200 bezeichnet.

Das System 200 umfasst einen Verbraucher 1, bei dem es sich insbesondere um ein (HTSL-)Kabelsystem handeln kann. Dieses wird unter Verwendung von flüssigem Stickstoff, der in einem Kreislaufstrom 2 geführt wird, gekühlt. Nach der Kühlung des Verbrauchers 1 wird der flüssige Stickstoff in dem Kreislaufstrom 2 auf einem Temperaturniveau von beispielsweise ca. 73 K und einem Druckniveau von beispielsweise ca. 10 bar einer Flüssigstickstoffpumpe bzw. Kreislaufpumpe 3 zugeführt, welche von einem Druckregelsystem 4 geregelt werden kann.

Die Temperatur des Stickstoffs in dem Kreislaufstrom 2 erhöht sich hierdurch auf beispielsweise ca. 74 K. Der Stickstoff in den Kreislaufstrom 2 wird anschließend einer Unterkühlung in einem Unterkühler 11 eines insgesamt mit 10 bezeichneten offenen Kältesystems zugeführt und dort in einem Unterkühlungswärmetauscher 15 auf ein Temperaturniveau von beispielsweise ca. 67 K abgekühlt. Stromab des Unterkühlers 11 liegt der Stickstoff in dem Kreislaufstrom 2 auf diesem Temperaturniveau und auf einem Druckniveau von beispielsweise ca. 15 bar vor und wird erneut zur Kühlung des Verbrauchers 1 eingesetzt.

Das offene Kältesystem 10 umfasst eine mechanische Vakuumpumpe 12, die Stickstoffdampf aus dem Unterkühler 11 bzw. aus dessen Verdampfungsraum abzieht und hierdurch ein Druckniveau in dem Unterkühler 11 bzw. in dessen Verdampfungsraum auf einen Wert von beispielsweise ca. 0,2 bar verringert. Ein Temperaturniveau des in dem Unterkühler 11 bzw. in dessen Verdampfungsraum vorliegenden flüssigen Stickstoffs (»Badstickstoff«) verringert sich hierdurch auf einen Wert von beispielsweise ca. 65 K.

Zum Ausgleich entsprechender Verdampfungsverluste ist ein Flüssigstickstoffspeicher 13 vorgesehen, der beispielsweise unter Verwendung einer Luftzerlegungsanlage und/oder durch externe Betankung befüllt werden kann. Im dargestellten Beispiel weist der Flüssigstickstoffspeicher 13 eine Einrichtung zur Druckaufbauverdampfung 14 auf.

Wie erwähnt ist der Betrieb eines entsprechenden offenen Kältesystems 10 aus energetischer Sicht eher nachteilig, da hier typischerweise der mittels der Vakuumpumpe 12 abgezogene Stickstoff an die Atmosphäre (amb) abgeführt wird. Alternativ, aber nicht zusätzlich zu einem entsprechenden offenen Kältesystem 10 kann daher im Stand der Technik auch eine geschlossenes Kältesystem 20 mit einem Unterkühler 11 und einem Unterkühlungswärmetauscher 17 eingesetzt werden, dass hier ausschnittsweise veranschaulicht ist.

In diesem wird der Stickstoff in dem Unterkühler 11, der grundsätzlich vergleichbar wie der Unterkühler 11 eines offenen Kältesystems ausgebildet sein kann, unter Verwendung einer geeigneten Kältemaschine, die, wie erwähnt, insbesondere einen oder mehrere Stirling-Kühler und/oder einen oder mehrere, unter Verwendung von Neon und/oder Helium betriebene Brayton-Kühler umfassen kann, gekühlt.

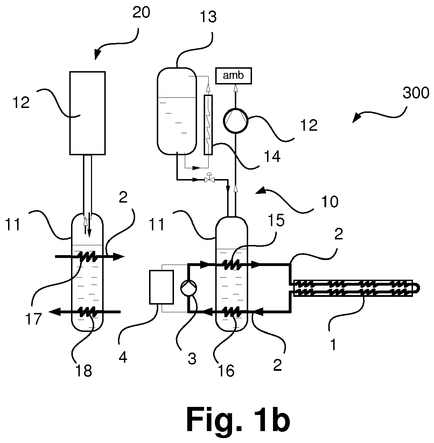

In Figur 1b ist ein System gemäß dem Stand der Technik in vereinfachter schematischer Darstellung gezeigt und insgesamt mit 300 bezeichnet. Das System 300 ist ähnlich wie das System 200 gemäß Figur 1 a aufgebaut, jedoch mit einem zusätzlichen Unterkühlungswärmetauscher 16 in dem offenen Kältesystem 10 (bzw. einem zusätzlichen Unterkühlungswärmetauscher 18 in dem geschlossenen Kältesystem 20) stromauf der Pumpe 3 versehen.

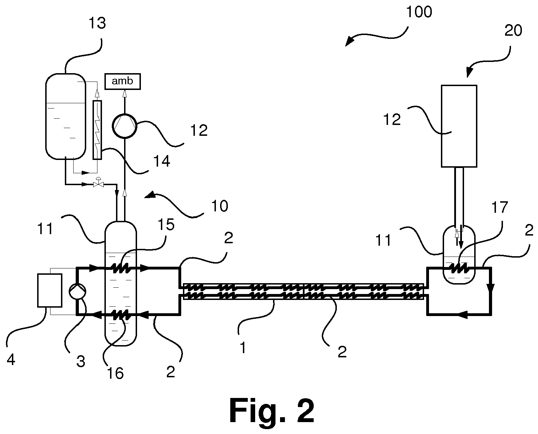

In Figur 2 ist ein System gemäß einer Ausführungsform der Erfindung in vereinfachter schematischer Darstellung gezeigt und insgesamt mit 100 bezeichnet.

Das System 100 umfasst im Wesentlichen die bereits unter Bezugnahme auf Figur 1 a und 1 b bzw. die dort gezeigten Systeme 200 und 300 erläuterten Komponenten. Jedoch sind in dem System 100 sowohl das offene Kältesystem 10 als auch das geschlossene Kältesystem 20 bereitgestellt.

Der flüssige Stickstoff des Kreislaufstroms 2 wird in dem System 200 nach der Unterkühlung in dem Unterkühler 11 des offenen Kältesystems 10 bzw. dessen Unterkühlungswärmetauscher 15 zur Kühlung des Verbrauchers 1 eingesetzt, anschließend jedoch nicht zur Pumpe 3 zurückgeführt sondern zunächst in dem Unterkühler 11 des geschlossenen Kältesystems 20 nochmals abgekühlt.

Die bereits bezüglich des Systems 200 gemäß Figur 1 erläuterten Temperatur-und Druckniveaus beim Eintritt in den und beim Austritt aus dem Unterkühler 11 des offenen Kältesystems 10 liegen auch in dem System 100 vor. Nach der Verwendung zur Kühlung des Verbrauchers 2 und vor dem Eintritt in den Unterkühler 11 des geschlossenen Kältesystem bis 20 liegt der flüssige Stickstoff des Kreislaufstroms 2 auf einem Temperaturniveau von beispielsweise ca. 73 K vor.

In dem Unterkühler 11 des geschlossenen Kältesystem 20 wird der flüssige Stickstoff des Kreislaufstroms 2 auf ein Temperaturniveau von beispielsweise ca. 67 K abgekühlt und auf diesem Temperaturniveau erneut zur Kühlung des Verbrauchers 1 eingesetzt. Der Stickstoff des Kreislaufstroms 2 wird der Pumpe 3 auf einem Druckniveau von beispielsweise ca. 10 bar und einem Temperaturniveau von beispielsweise ca. 73 K zugeführt und zuvor erneut in dem Unterkühler 11 des offenen Kältesystems 10 bzw. dessen Unterkühlungswärmetauscher 11 gekühlt.

## Patentansprüche

1. Verfahren zur Kühlung eines Verbrauchers unter Verwendung von flüssigem Stickstoff, der in einem Kreislauf geführt, durch indirekten Wärmeaustausch mit abgekühltem flüssigem Stickstoff abgekühlt und einem Wärmeaustausch mit dem Verbraucher unterworfen wird, **dadurch gekennzeichnet, dass**
- der zur Abkühlung des in den Kreislauf geführten flüssigen Stickstoffs verwendete abgekühlte flüssige Stickstoff zu einem ersten Anteil in einem offenen Kältesystem (10) durch Druckreduktion und Abführen von sich bildendem Stickstoffdampf und zu einem zweiten Anteil in einem geschlossenen Kältesystem (20) unter Verwendung einer oder mehrerer Kältemaschinen abgekühlt wird,
- das offene Kältesystem (10) und das geschlossene Kältesystem (20) zum Kühlen einer Stromführung (1) mit einem ersten Ende und einem zweiten Ende verwendet wird, wobei das offene Kältesystem (10) an dem ersten Ende der Stromführung (1) und das geschlossene Kältesystem (20) an dem zweiten Ende der Stromführung (1) angeordnet wird, und
- Kühlleistung einem ersten Zeitraum in einer ersten, geringeren Gesamtkühlleistungsmenge und
in einem zweiten Zeitraum einer zweiten, höheren Gesamtkühlleistungsmenge bereitgestellt wird, wobei
ein erster Anteil der Gesamtkühlleistungsmenge mittels des offenen (10) und ein zweiter Anteil der Gesamtkühlleistungsmenge mittels des geschlossenen Kältesystems (20) bereitgestellt wird und
der erste Anteil in dem ersten Zeitraum auf einen geringeren Wert als in dem zweiten Zeitraum eingestellt wird.

2. Verfahren nach Anspruch 1, bei dem der zweite Anteil in dem ersten Zeitraum auf denselben Wert eingestellt wird wie in dem zweiten Zeitraum.

3. Verfahren nach einem der vorstehenden Ansprüche, bei dem der in dem Kreislauf geführte flüssige Stickstoff in dem offenen Kältesystem (10) und in dem geschlossenen Kältesystem (20) jeweils von einem Temperaturniveau von 70 bis 78 K auf ein Temperaturniveau von 65 bis 70 K abgekühlt wird.

4. Verfahren nach einem der vorstehenden Ansprüche, bei dem der in dem Kreislauf geführte flüssige Stickstoff in dem offenen Kältesystem (10) und dem geschlossenen Kältesystem (20) auf einem Druckniveau von 5 bis 20 bar abgekühlt wird.

5. Verfahren nach einem der vorstehenden Ansprüche, bei dem die verwendete Kältemaschine oder Kältemaschinen eine unter Verwendung von Neon und/oder Helium betriebene Stirlng- oder Brayton-Kältemaschine umfassen.

6. Vorrichtung zur Kühlung eines Verbrauchers unter Verwendung von flüssigem Stickstoff, die dafür eingerichtet ist, den flüssigen Stickstoff in einem Kreislauf zu führen, durch indirekten Wärmeaustausch mit abgekühltem flüssigem Stickstoff abzukühlen und einem Wärmeaustausch mit dem Verbraucher zu unterwerfen, **dadurch gekennzeichnet, dass**
- zur Abkühlung eines ersten Anteils des flüssigen Stickstoffs, der zur Abkühlung des in den Kreislauf geführten flüssigen Stickstoffs vorgesehen ist, ein offenes Kältesystem (10) bereitgestellt ist, das dafür eingerichtet ist, den ersten Anteil des flüssigen Stickstoffs durch Druckreduktion und Abführen von sich bildendem Stickstoffdampf abzukühlen,
- zur Abkühlung eines zweiten Anteils des flüssigen Stickstoffs, der zur Abkühlung des in dem Kreislauf geführten flüssigen Stickstoffs vorgesehen ist, ein geschlossenes Kältesystem (20) bereitgestellt ist, das eine oder mehrere Kältemaschinen umfasst, ,
- das offene Kältesystem (10) und das geschlossene Kältesystem (20) zum Kühlen einer Stromführung (1) mit einem ersten Ende und einem zweiten Ende eingerichtet sind, wobei das offene Kältesystem (10) an dem ersten Ende der Stromführung (1) und das geschlossene Kältesystem (20) an dem zweiten Ende der Stromführung (1) angeordnet wird, und
- die Vorrichtung dafür eingerichtet ist, Kühlleistung einem ersten Zeitraum in einer ersten, geringeren Gesamtkühlleistungsmenge und in in einem zweiten Zeitraum einer zweiten, höheren Gesamtkühlleistungsmenge bereitzustellen, wobei ein erster Anteil der Gesamtkühlleistungsmenge mittels des offenen Kältesystems (10) und ein zweiter Anteil der Gesamtkühlleistungsmenge mittels des geschlossenen Kältesystems (20) bereitgestellt wird und der erste Anteil in dem ersten Zeitraum auf einen geringeren Wert als in dem zweiten Zeitraum einstellbar ist.

7. Vorrichtung nach Anspruch 6, bei dem die verwendete Kältemaschine oder Kältemaschinen eine unter Verwendung von Neon und/oder Helium betriebene Stirling- oder Brayton-Kältemaschine umfassen.

8. System (100) mit einer zu kühlenden Stromführung (1), **gekennzeichnet durch** eine Vorrichtung nach Ansprüchen 6 und 7.
